# EUROPEAN PATENT APPLICATION

(11) **EP 4 797 905 A1**
(43) Date of publication of application: **26.08.2026**
(21) Application number: 25880121.6
(22) Date of filing: 27.06.2025
(51) Int. Cl.: H10D 99/00, H10D 30/67, H10D 62/40, H10P 10/00

(54) **METHOD FOR MANUFACTURING INDIUM-BASED COMPOSITE OXIDE SEMICONDUCTOR LAYER HAVING PREFERENTIALLY ORIENTED CRYSTALLINITY, AND THIN-FILM TRANSISTOR INCLUDING IN- BASED COMPOSITE OXIDE SEMICONDUCTOR LAYER**

(30) Priority: 18.10.2024 KR 20240142891
(71) Applicant: IUCF-HYU (Industry-University Cooperation Foundation Hanyang University), Seoul 04763 (KR)
(72) Inventor: JEONG, Jae Kyeong, Seoul 04983 (KR); CHUNG, Sang Won, Seoul 04727 (KR)
(74) Representative: Prüfer & Partner mbB Patentanwälte · Rechtsanwälte
(86) International application number: PCT/KR2025/009108
(87) International publication number: WO 2026/084176

(57) **Abstract**

Provided are a method for manufacturing an In-based composite oxide semiconductor layer having preferential orientation crystallinity and a thin film transistor including the In-based composite oxide semiconductor layer. A method for crystallizing the In-based composite oxide semiconductor layer includes forming an In-based composite oxide semiconductor layer on a substrate and performing a first heat treatment on the substrate. The first heat treatment breaks metal-oxygen bonds in the In-based composite oxide semiconductor layer but maintains the amorphous state of the In-based composite oxide semiconductor layer after the first heat treatment. In-based oxide conductor patterns are formed on both ends of the In-based composite oxide semiconductor layer, and a second heat treatment is performed on the substrate to crystallize the In-based oxide conductor patterns to have bixbyite crystals. A third heat treatment is performed on the substrate to induce crystallization of the In-based composite oxide semiconductor layer by the crystallized In-based oxide conductor patterns, thereby crystallizing the In-based composite oxide semiconductor layer to be preferentially oriented in a [222] direction.

## Description

### [Technical Field]

The present invention relates to semiconductor devices, and specifically to a transistor having an oxide semiconductor layer.

### [Background Art]

As a semiconductor film of a transistor, an amorphous silicon film or a polycrystalline silicon film is used depending on the purpose. For example, in the case of a transistor included in a large-sized display device, it is preferable to use an amorphous silicon film that can be formed with relatively uniform characteristics even when formed over a large area. On the other hand, in the case of a device including a driver circuit or the like, it is preferable to use a polycrystalline silicon film that can exhibit high field-effect mobility. As a method for forming the polycrystalline silicon film, a method of subjecting an amorphous silicon film to high-temperature heat treatment or treatment with laser light is known.

Recently, research on using an oxide semiconductor for a channel layer of a transistor has been conducted in, for example, JP 2006-165528. However, the oxide semiconductor layer is mostly an amorphous layer, and is known to be electrically and chemically unstable and difficult to exhibit sufficient field-effect mobility.

### [Disclosure]

### [Technical Problem]

The objective of the present disclosure is to provide a metal oxide semiconductor layer exhibiting high field-effect mobility and a thin film transistor comprising the same.

The technical problems to be solved by the present disclosure are not limited to those mentioned above, and other technical problems not mentioned herein will be clearly understood by those skilled in the art from the following description.

### [Technical Solution]

To achieve the aforementioned objective, an aspect of the present disclosure provides a method for crystallizing an In-based composite oxide semiconductor layer. First, an In-based composite oxide semiconductor layer (Indium-based composite oxide semiconductor layer) is formed on a substrate, followed by a first heat treatment of the substrate. The first heat treatment is performed to disrupt metal-oxygen bonds within the In-based composite oxide semiconductor layer while maintaining the amorphous state of the In-based composite oxide semiconductor layer. Subsequently, In-based oxide conductor patterns are formed on both ends of the In-based composite oxide semiconductor layer. The substrate then undergoes a second heat treatment to crystallize the In-based oxide conductor patterns into a bixbyite crystal structure. A third heat treatment is performed on the substrate to induce crystallization of the In-based composite oxide semiconductor layer by the crystallized In-based oxide conductor patterns, thereby crystallizing the In-based composite oxide semiconductor layer such that it is preferentially oriented in the [222] direction.

The In-based composite oxide semiconductor layer may be a ternary oxide layer or a quaternary oxide layer containing other metallic elements in addition to indium. The ternary oxide may be In-Ga-O (IGO) or In-Zn-O (IZO). The quaternary oxide may be In-Ga-Zn-O (IGZO) or In-Zn-Sn-O (IZTO).

The first heat treatment may be conducted at a temperature greater than 300 °C and less than 500 °C. Specifically, the first heat treatment may be performed at a temperature ranging from 350 to 450 °C. The first heat treatment may be carried out in an oxygen atmosphere for a duration of 0.5 to 2 hours.

The In-based oxide conductor patterns may be In-Sn-O (ITO) or In-Zn-O (IZO) patterns. The second heat treatment may be performed at a temperature between 180 and 220 °C. The In-based composite oxide semiconductor layer may maintain its amorphous state even after the second heat treatment.

Prior to the third heat treatment of the substrate, a passivation layer covering the crystallized In-based oxide conductor patterns may be formed. The passivation layer may be a silicon oxide layer.

The crystallized In-based composite oxide semiconductor layer may exhibit a ratio of (222) peak intensity to (400) peak intensity in an X-ray diffraction (XRD) spectrum ranging from 6 to 8. The lattice mismatch degree between the crystallized In-based oxide conductor pattern and the In-based composite oxide semiconductor layer, of which crystallization is induced by the pattern, may be less than 2.5%. The crystallinity of the crystallized In-based composite oxide semiconductor layer may decrease from both ends in contact with the In-based oxide conductor patterns toward the center thereof. In the crystallized In-based composite oxide semiconductor layer, the edge regions of the area exposed between the In-based oxide conductor patterns may crystallize first, while the center portion remains in an amorphous state.

To achieve the aforementioned objective, an aspect of the present disclosure provides a method for manufacturing a thin film transistor. First, a gate electrode is formed on a substrate, and a gate insulating layer is formed on the gate electrode. A channel layer, which is an In-based composite oxide semiconductor layer (Indium-based composite oxide semiconductor layer), is formed on the gate insulating layer. The substrate is subjected to a first heat treatment to disrupt metal-oxygen bonds within the In-based composite oxide semiconductor layer while maintaining its amorphous state. In-based oxide conductor patterns are formed on both ends of the In-based composite oxide semiconductor layer, and the substrate is subjected to a second heat treatment to crystallize the In-based oxide conductor patterns into a bixbyite crystal structure. A third heat treatment is then performed to induce crystallization of the In-based composite oxide semiconductor layer by the crystallized In-based oxide conductor patterns, such that the In-based composite oxide semiconductor layer is preferentially oriented in the [222] direction.

The crystallized In-based oxide conductor patterns may be source/drain electrodes.

To achieve the aforementioned objective, an aspect of the present disclosure provides a thin film transistor. The thin film transistor includes a gate electrode. An In-based composite oxide semiconductor layer, which overlaps the gate electrode, possesses a bixbyite crystal structure, and is preferentially oriented in the [222] direction, is disposed. A gate insulating layer is disposed between the gate electrode and the In-based composite oxide semiconductor layer. Source and drain electrodes are electrically connected to both ends of the In-based composite oxide semiconductor layer, respectively.

The crystallinity of the In-based composite oxide semiconductor layer may decrease from both ends toward the center portion. The In-based composite oxide semiconductor layer may be configured such that edge portions of the channel region is crystallized while the center portion remains in an amorphous state.

The In-based composite oxide semiconductor layer may exhibit a ratio of (222) peak intensity to (400) peak intensity in an XRD (X-ray diffraction) spectrum ranging from 6 to 8. The source/drain electrodes may be In-based oxide conductor patterns crystallized to have a bixbyite crystal structure. The crystallized In-based composite oxide semiconductor layer may be one in which crystallization is induced by the crystallized In-based oxide conductor patterns. The lattice mismatch degree between the crystallized In-based oxide conductor pattern and the In-based composite oxide semiconductor layer, of which crystallization is induced by the pattern, may be less than 2.5%.

### [Advantageous Effects]

According to embodiments of the present disclosure, it is possible to provide an In-based composite oxide semiconductor layer having a single-crystal-like crystallinity through preferential orientation, and a thin film transistor including the same as a channel layer to exhibit excellent characteristics such as high field-effect mobility.

However, the effects of the present disclosure are not limited to those mentioned above, and other effects not specifically mentioned herein will be clearly understood by those skilled in the art from the following description.

### [Description of Drawings]

FIGS. 1 to 3 are cross-sectional views illustrating a method for manufacturing a thin film transistor according to an embodiment of the present disclosure.
FIGS. 4a and 4b are a cross-sectional view and a top view, respectively, illustrating the crystallization of the semiconductor layer induced by the crystallized In-based oxide conductor patterns.
FIG. 5 is a perspective view illustrating a TFT manufactured in any one of the TFT Preparation examples.
FIG. 6 is a perspective view illustrating a specimen manufactured in any one of the IGO semiconductor layer crystallinity evaluation examples.
FIG. 7 illustrates XRD (X-ray diffraction) spectra for IGO layers manufactured by the methods according to IGO layer crystallinity evaluation examples 1 to 5.
FIG. 8 illustrates XRD spectra for IGO layers of TFTs manufactured by the methods according to TFT Preparation examples 1, 3, and 6.
FIG. 9 illustrates XRD spectra for IGO layers of TFTs manufactured by the methods according to TFT Preparation examples 2, 3, 4, and 5.
FIG. 10 shows scanning electron microscope (SEM) images of the IGO layers of the TFTs according to TFT Preparation examples 2, 3, 4, and 5, classified by the third heat treatment temperature.
FIG. 11 illustrates XRD spectra for IGO layers manufactured by the methods according to IGO layer crystallinity evaluation examples 6 to 8.
FIG. 12a shows a schematic view of the TFT obtained in TFT Preparation example 3, and FIG. 12b shows a TEM (Transmission Electron Microscopy) image taken along the cross-section A-A' of the TFT obtained in TFT Preparation example 3, an HAADF-STEM (High-Angle Annular Dark Field Scanning Transmission Electron Microscopy) image magnifying a portion of the TEM-imaged area, and an FFT (Fast Fourier Transform) pattern inserted therein.
FIG. 13 is a TEM image of another portion of the cross-section A-A' of the TFT obtained in TFT Preparation example 3.
FIGS. 14a and 14b are EBSD (Electron Back Scattering Diffraction) images of IGO layers obtained according to TFT Preparation example 3 (with ITO) and IGO layer crystallinity evaluation example 7 (without ITO), respectively; and FIG. 14c is a graph showing the distribution of grain boundaries with respect to the difference in grain orientation (rotation angle) obtained from FIGS. 14a and 14b.
FIGS. 15a, 15b, 15c, 15d, 15e, and 15f are images observing the crystals of samples prepared according to TFT Preparation Example 3, in which the third heat treatment was performed for 0 min (before treatment), 1 min, 30 min, 1 hr, 5 hr, and 10 hr, respectively.
FIGS. 16a and 16d are graphs representing the transfer characteristics (I_{DS}-V_{GS}) and output characteristics (I_{D}-V_{D}) of the TFT obtained in TFT Preparation example 1, respectively; FIGS. 16b and 16e are graphs representing the transfer characteristics (I_{DS}-V_{GS}) and output characteristics (I_{D}-V_{D}) of the TFT obtained in TFT Preparation example 3, respectively; and FIGS. 16c and 16f are graphs representing the transfer characteristics (I_{DS}-V_{GS}) and output characteristics (I_{D}-V_{D}) of the TFT obtained in TFT Preparation example 6, respectively.
FIGS. 17a, 17b, 17c, and 17d are graphs illustrating the reliability characteristics of the TFTs obtained in TFT Preparation examples 1, 3, and 6, and shows the amount of threshold voltage shift according to stress time in PBS (Positive-Bias Stress), PBTS (Positive-Bias Temperature Stress), NBS (Negative-Bias Stress), and NBTS (Negative-Bias Temperature Stress), respectively.
FIGS. 18a, 18b, and 18c are graphs comparing the mobility, SS, and threshold voltage of the TFTs obtained in TFT Preparation examples 2, 3, 4, and 5.
FIG. 19 shows XRD graphs for the IGO layers of the TFTs obtained in TFT Preparation Example 3, TFT Comparative Example 1, and TFT Comparative Example 2.
FIGS. 20a, 20b, and 20c show SEM images illustrating cross-sections of the portions where the source electrodes are stacked on the IGO layers of the TFTs obtained in TFT Preparation Example 3, TFT Comparative Example 1, and TFT Comparative Example 2, respectively, and further display FFT (fast Fourier transform) patterns inserted in these images.
FIGS. 21a, 21b, and 21c are graphs comparing the mobility, SS, and threshold voltage of the TFTs obtained in TFT Preparation Example 3, TFT Comparative Example 1, and TFT Comparative Example 2.
FIG. 22 shows XRD (X-ray diffraction) spectra for the IGZO layers manufactured by the method according to IGZO Layer Crystallinity Evaluation Examples 1 to 3.
FIG. 23 shows XRD spectra for the IGZO layers of the TFTs manufactured by the method according to TFT Preparation Examples 7, 8, and 9.

### [Modes of the Invention]

Hereinafter, preferred embodiments according to the present invention will be described in more detail with reference to the accompanying drawings to explain the present invention in further detail. However, the present invention is not limited to the embodiments described herein and may be embodied in other forms. In the drawings, when a layer is referred to as being "on" another layer or substrate, it may be formed directly on the other layer or substrate, or a third layer may be interposed therebetween. In the present embodiments, "first," "second," or "third" is not intended to impose any limitation on components, but should be understood as a term for distinguishing the components.

In this specification, "preferred orientation" means that the majority of a thin film has the same crystal plane; in other words, crystals are grown in the same direction. Specifically, even if a preferentially oriented thin film comprises a plurality of crystals, each of these crystals shares the same crystal plane in the out-of-plane direction (surface direction) of the thin film. Furthermore, in the in-plane direction (cross-sectional direction), these crystals may have crystal planes in a direction different from the out-of-plane direction, yet share the same crystal plane direction among themselves.

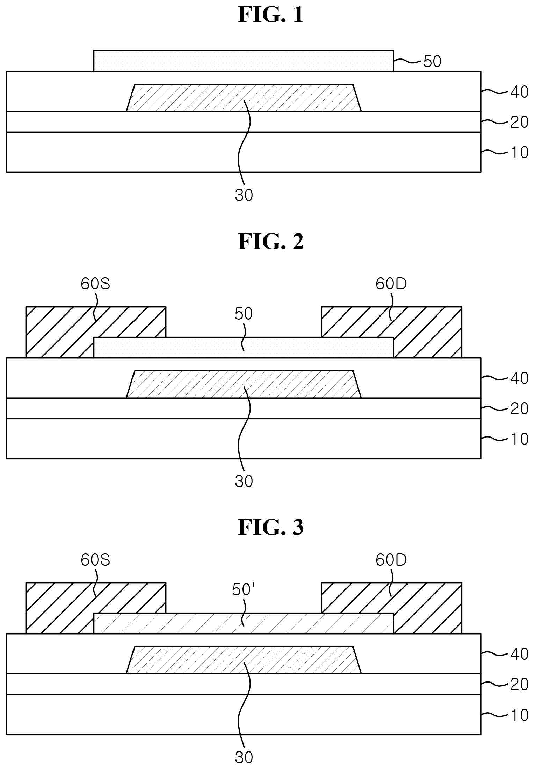

FIGS. 1 to 3 are cross-sectional views illustrating a method for manufacturing a thin film transistor according to an embodiment of the present disclosure.

Referring to FIG. 1, a substrate 10 may be provided. The substrate 10 may be a semiconductor, metal, glass, or polymer substrate. A lower insulating layer 20 may be disposed on the substrate 10. The lower insulating layer 20 may serve to prevent the influx of impurities from the substrate 10 or may be an insulating layer covering other elements formed on the substrate 10.

A gate electrode 30 extending in one direction may be formed on the substrate 10. The gate electrode 30 may be formed using Al, Cr, Cu, Ta, Ti, Mo, W, Si, or an alloy thereof. A gate insulating layer 40 may be formed on the gate electrode 30. The gate insulating layer 40 may be a silicon oxide layer, a silicon oxynitride layer, an aluminum oxide layer, an aluminum oxynitride layer, or a composite layer thereof.

A semiconductor layer 50 overlapping the gate electrode 30 may be formed on the gate insulating layer 40. The semiconductor layer 50 may be an Indium-based (In-based) composite oxide layer and may be in an amorphous state as deposited.

The In-based composite oxide semiconductor layer is a ternary oxide or a quaternary oxide layer containing another metal element in addition to indium, may be an oxide layer having semiconducting properties, and may contain In at 70 to 85 at%, specifically 75 to 80 at%, based on the total number of atoms of the metal elements. The ternary Indium-based composite oxide layer may be an In-Ga-O (IGO) layer or an In-Zn-O (IZO) layer, and the quaternary Indium-based composite oxide layer may be an In-Ga-Zn-O (IGZO) layer or an In-Zn-Sn-O (IZTO) layer.

The semiconductor layer 50 may be formed using various methods used in the art, and as an example, may be formed using a physical vapor deposition method such as sputtering or a chemical vapor deposition method such as chemical vapor deposition or atomic layer deposition, and may also be patterned using various methods used in the art. The semiconductor layer 50 may be formed to have a thickness of several nm to tens of nm, for example, a thickness of 5 to 50 nm, or as an example, a thickness of 10 to 30 nm.

The semiconductor layer 50 may be heat-treated. This may be performed by subjecting the substrate to a first heat treatment. The first heat treatment may be performed in an oxygen atmosphere, specifically in air, for 0.5 to 2 hours. Metal-oxygen bonds in the semiconductor layer 50 may be sufficiently broken by the first heat treatment, but an amorphous state may be maintained without being crystallized. To this end, the first heat treatment temperature may be higher than 300 °C and lower than 500 °C, specifically 350 °C to 450 °C, more specifically 380 °C to 420 °C, and as an example, 400 °C.

Referring to FIG. 2, In-based oxide conductor patterns 60S and 60D may be formed on both ends of the semiconductor layer 50 so that a partial surface of the semiconductor layer 50, specifically, a channel region which is a region where the semiconductor layer 50 overlaps the gate electrode 20, is exposed between the In-based oxide conductor patterns 60S and 60D. The In-based oxide conductor patterns 60S and 60D may be patterns having metallic properties rather than semiconducting properties, and may be layers containing In at 88 to 100 at%, specifically 89 to 91 at%, based on the total number of atoms of the metal elements. The In -based oxide conductor patterns 60S and 60D having metallic properties may be an In-Sn-O (ITO) layer or an In-Zn-O (IZO) layer. The In -based oxide conductor patterns 60S and 60D may be in an amorphous state as deposited.

After depositing the In -based oxide conductor patterns 60S and 60D, the In-based oxide conductor patterns 60S and 60D may be crystallized. This may be performed through a second heat treatment. Specifically, this may be performed by subjecting the substrate to the second heat treatment. The second heat treatment may be performed in an oxygen atmosphere, specifically in air, for 0.5 to 2 hours, and a second heat treatment temperature may be 180 to 220 °C, specifically 200 °C.

The crystallized In-based oxide conductor patterns 60S and 60D may have a Bixbyite crystal having a {111} crystal plane. Specifically, the crystallized In-based oxide conductor patterns 60S and 60D may have preferred orientation in a [222] direction. Specifically, the source/drain electrodes 60S and 60D, which are In-based composite oxide layers having metallic properties, may have a (222) peak intensity greater than a (400) peak intensity in an X-ray diffraction (XRD) spectrum.

Even during the second heat treatment process, the semiconductor layer 50 may remain in an amorphous state without being crystallized.

Referring to FIG. 3, a passivation layer (not shown) may be formed to cover the crystallized In-based oxide conductor patterns 60S and 60D and the semiconductor layer 50 of FIG. 2 exposed therebetween. The passivation layer may be a silicon oxide layer. The silicon oxide layer may be formed by various methods such as chemical vapor deposition and atomic layer deposition, but as an example, may be formed using a Plasma Enhanced Atomic Layer Deposition (PEALD) method. The passivation layer may be formed to have a thickness of several nm, for example, about 3 to 10 nm.

After forming the passivation layer, the substrate may be subjected to a third heat treatment. The third heat treatment may be performed in an oxygen atmosphere, specifically in air, for 0.5 to 2 hours. During the third heat treatment process, the semiconductor layer 50 in FIG. 2 may be changed into a crystallized semiconductor layer 50' as its crystallization is induced by the crystallized In-based oxide conductor patterns 60S and 60D.

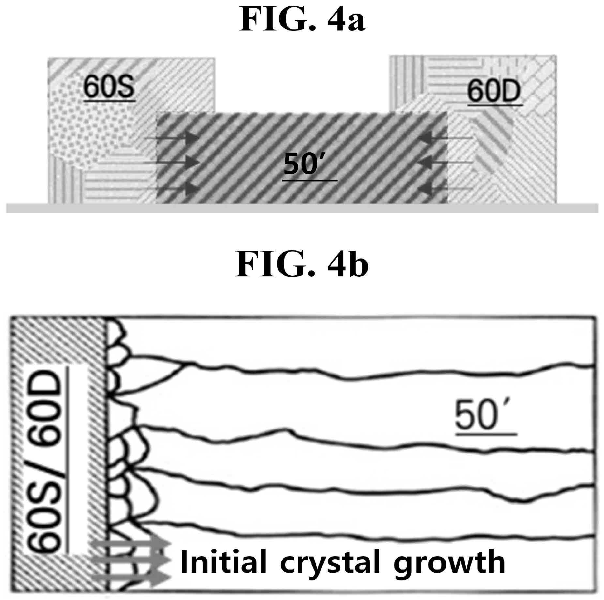

FIGS. 4a and 4b are a cross-sectional view and a top view, respectively, illustrating the crystallization of the semiconductor layer induced by the crystallized In-based oxide conductor patterns.

Referring to FIG. 3, FIG. 4a, and FIG. 4b together, the semiconductor layer 50', in which crystallization is induced by the crystallized In-based oxide conductor patterns 60S and 60D, may have Bixbyite crystals with {111} crystal planes, similar to the patterns 60S and 60D. Specifically, the crystallized semiconductor layer 50' may have a preferred orientation in a [222] direction to have a single-crystal-like crystal structure. Specifically, the crystallized semiconductor layer 50' may have a very high ratio of (222) peak intensity to (400) peak intensity, which is a (222)/(400) intensity ratio, in an X-ray diffraction (XRD) spectrum. The (222)/(400) intensity ratio may be very high, ranging from 6 to 8, and specifically from 7 to 7.5.

In addition, the crystallization of the semiconductor layer 50' induced by the crystallized In-based oxide conductor patterns 60S and 60D results in a very low lattice mismatch degree (less than about 2.5%) between the semiconductor layer 50' and the crystallized In-based oxide conductor patterns 60S and 60D; thus, they can be considered to be in a lattice-matched state.

Specifically, before the third heat treatment, the semiconductor layer 50 of FIG. 2 is in an amorphous state in which metal-oxygen bonds are sufficiently broken. However, during the third heat treatment, the metal-oxygen bonds in the semiconductor layer 50 of FIG. 2 may be rearranged starting from regions adjacent to the crystallized In-based oxide conductor patterns 60S and 60D. As this rearrangement propagates in a horizontal direction into the semiconductor layer, the entire semiconductor layer 50 may be converted into a crystalline state, specifically a single-crystal-like crystalline state having preferred orientation, even at a relatively low temperature. This process may imply that the semiconductor layer 50' is horizontally induced-crystallized or epitaxially crystallized by the crystallized In-based oxide conductor patterns 60S and 60D. Since the induced crystallization of the semiconductor layer 50' proceeds from both ends contacting the In-based oxide conductor patterns 60S and 60D toward the center of the semiconductor layer 50', the crystallinity may decrease from both ends contacting the In-based oxide conductor patterns 60S and 60D toward the center of the semiconductor layer 50'. Additionally, in the region where the semiconductor layer 50' is exposed between the In-based oxide conductor patterns 60S and 60D, which is the channel region, the edge portion of the channel region may crystallize first while the center may remain in an amorphous state.

In the third heat treatment process, the semiconductor layer 50' may form an ohmic contact with the In-based oxide conductor patterns 60S and 60D.

The In-based oxide conductor patterns 60S and 60D may be source/drain electrodes. However, in another example, after the third heat treatment, the passivation layer and the In-based oxide conductor patterns 60S and 60D may be removed, and metal patterns, specifically metal patterns such as Ta, Ti, W, or Mo, may be formed on both ends of the semiconductor layer 50' to form source/drain electrodes.

In the above example, a thin film transistor having a bottom-gate/top-contact structure has been described as an example, but the present invention is not limited thereto and may also be applied to a thin film transistor having a bottom-gate/bottom-contact structure, a top-gate/top-contact structure, or a top-gate/bottom-contact structure. Here, the top-gate structure means a structure in which a metal oxide channel layer overlaps below a gate electrode, and the bottom-contact structure means a structure in which source and drain electrodes are electrically connected to a lower portion of the metal oxide channel layer.

Hereinafter, preferred examples are presented to facilitate understanding of the present invention. However, the following examples are only for facilitating understanding of the present invention, and the present invention is not limited by the following examples.

### TFT Preparation Examples 1-6

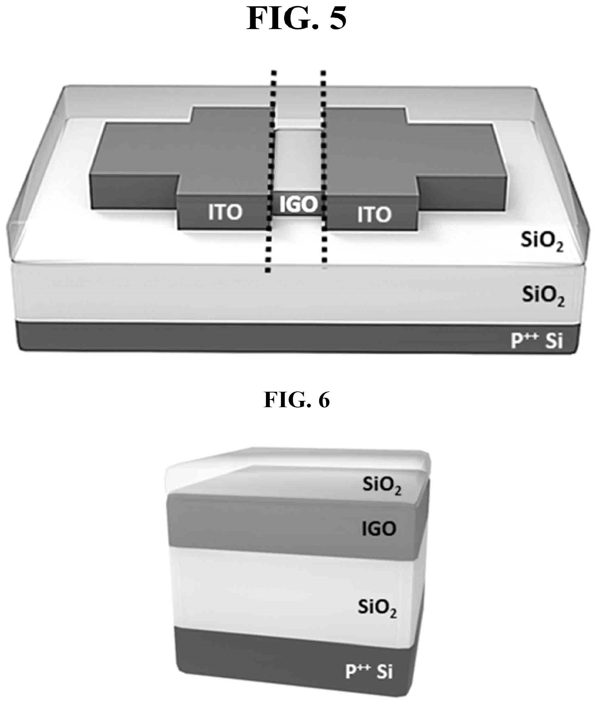

FIG. 5 is a perspective view illustrating a TFT manufactured in any one of the TFT Preparation examples.

Referring to FIG. 5, a p-type Si wafer (P⁺⁺ Si) was thermally oxidized to grow a 100 nm SiO₂ layer on the p-type Si wafer. An IGO semiconductor layer having a composition of a-In_{0.76}Ga_{0.24}O was deposited to a thickness of 20 nm on the SiO₂ layer using RF sputtering in an argon atmosphere and using a shadow mask. Sputtering targets were In₂O₃ and Ga₂O₃, the RF power and DC power were 50 W and 70 W, respectively, and the chamber pressure was 3 mTorr. Thereafter, the IGO semiconductor layer was heat-treated in air for 1 hour at a first heat treatment temperature shown in Table 1 below.

A shadow mask was placed on the heat-treated IGO semiconductor layer, and ITO was deposited using DC sputtering under an Ar atmosphere to form ITO source/drain electrodes having a thickness of 100 nm on both ends of the IGO semiconductor layer. At this time, the DC power was 50 W, and the operating pressure was 5 mTorr. The width of the IGO semiconductor layer was 1000 µm, and the length over which the IGO semiconductor layer was exposed between the source/drain electrodes, that is, the channel length, was 300 µm. Thereafter, a second heat treatment was performed at 200 °C for 1 hour in an air atmosphere to crystallize the ITO source/drain electrodes.

On the crystallized ITO source/drain electrodes, a 5 nm SiO₂ passivation layer was formed using a Plasma Enhanced Atomic Layer Deposition (PEALD) method in which a unit cycle including DIPAS (Di-isopropyl amino silane) supply/purge/O₂ plasma/purge steps was performed a plurality of times. Thereafter, the IGO semiconductor layer was crystallized for 1 hour in an air atmosphere at a third heat treatment temperature shown in Table 1 below.

### IGO Layer Crystallinity Evaluation Examples 1-5

A p-type Si wafer (P⁺⁺ Si) was thermally oxidized to grow a 100 nm SiO₂ layer on the p-type Si wafer. An IGO layer having a composition of a-In_{0.76}Ga_{0.24}O was deposited to a thickness of 20 nm on the SiO₂ layer using RF sputtering in an argon atmosphere. At this time, sputtering targets were In₂O₃ and Ga₂O₃, the RF power and DC power were 50 W and 70 W, respectively, and the chamber pressure was 3 mTorr. Thereafter, the IGO layer was heat-treated in air for 1 hour at a first heat treatment temperature shown in Table 1 below.

### IGO Layer Crystallinity Evaluation Examples 6-8

FIG. 6 is a perspective view illustrating a specimen manufactured in any one of the IGO semiconductor layer crystallinity evaluation examples.

Referring to FIG. 6, a p-type Si wafer (P⁺⁺ Si) was thermally oxidized to grow a 100 nm SiO₂ layer on the p-type Si wafer. An IGO layer having a composition of aIn_{0.76}Ga_{0.24}O was deposited to a thickness of 20 nm on the SiO₂ layer using RF sputtering in an argon atmosphere. At this time, the sputtering targets were In₂O₃ and Ga₂O₃, the RF power and DC power were 50 W and 70 W, respectively, and the chamber pressure was 3 mTorr. Thereafter, the IGO layer was heat-treated in air for 1 hour at a first heat treatment temperature shown in Table 1 below. The heat-treated IGO layer was subjected to a second heat treatment at 200 °C for 1 hour in an air atmosphere.

On the IGO layer subjected to the second heat treatment, a 5 nm SiO₂ passivation layer was formed using a Plasma Enhanced Atomic Layer Deposition (PEALD) method in which a unit cycle including DIPAS (Di-isopropyl amino silane) supply/purge/O₂ plasma/purge steps was performed a plurality of times. Thereafter, a third heat treatment was performed at 400 °C for 1 hour in an air atmosphere.

**[Table 1]**

| | 1^{st} Heat Treatment (Air, 1 hr) | 2^{nd} Heat Treatment (Air, 1 hr) | 3^{rd} Heat Treatment (Air, 1 hr) | State of IGO Layer |
|---|---|---|---|---|
| TFT Preparation Example 1 | 300 °C | 200 °C | 400 °C | Amorphous |
| TFT Preparation Example 2 | 400 °C | 200 °C | 300 °C | Amorphous |
| TFT Preparation Example 3 | 400 °C | 200 °C | 400 °C | Polycrystalline, (222) Preferred Orientation |
| TFT Preparation Example 4 | 400 °C | 200 °C | 500 °C | Polycrystalline, Random Orientation |
| TFT Preparation Example 5 | 400 °C | 200 °C | 600 °C | Polycrystalline, Random Orientation |
| TFT Preparation Example 6 | 500 °C | 200 °C | 400 °C | Polycrystalline, Random Orientation |
| IGO Crystallinity Evaluation Example 1 | 300 °C | - | - | Amorphous |
| IGO Crystallinity Evaluation Example 2 | 400 °C | - | - | Amorphous |
| IGO Crystallinity Evaluation Example 3 | 450 °C | - | - | Polycrystalline, (222) Preferred Orientation |
| IGO Crystallinity Evaluation Example 4 | 500 °C | - | - | Polycrystalline, (222) Preferred Orientation |
| IGO Crystallinity Evaluation Example 5 | 600 °C | - | - | Polycrystalline, Random Orientation |
| IGO Crystallinity Evaluation Example 6 | 300 °C | 200 °C | 400 °C | Amorphous |
| IGO Crystallinity Evaluation Example 7 | 400 °C | 200 °C | 400 °C | Amorphous |
| IGO Crystallinity Evaluation Example 8 | 500 °C | 200 °C | 400 °C | Polycrystalline, Random Orientation |

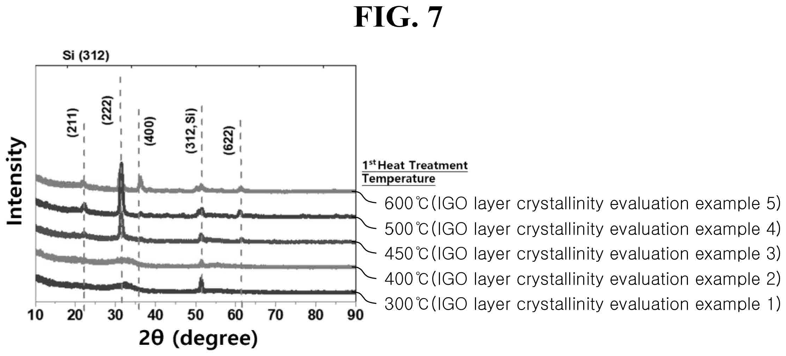

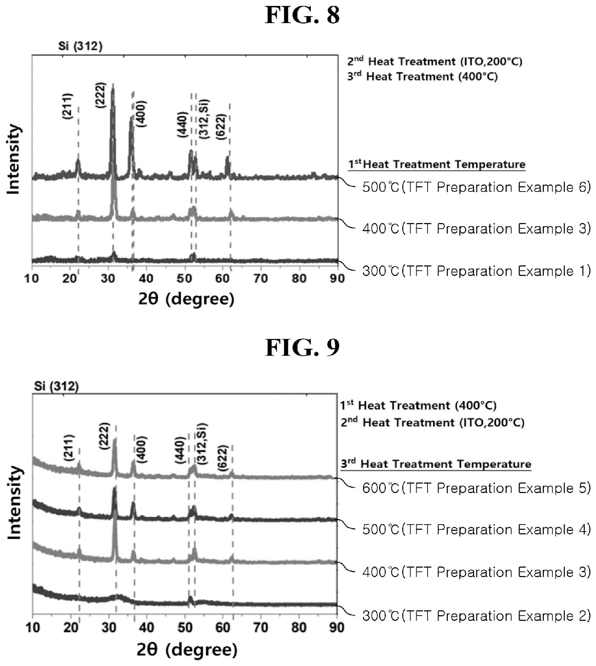

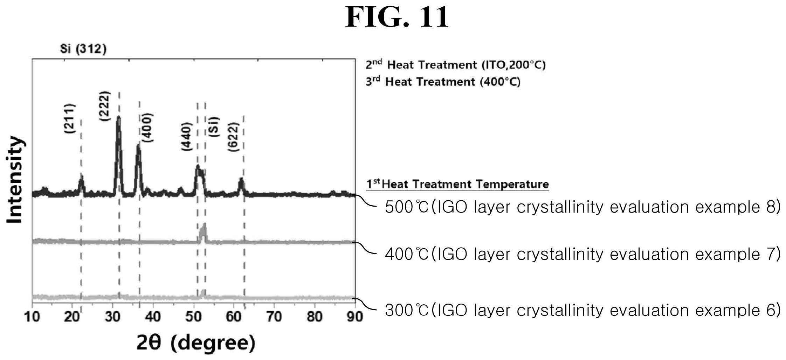

FIG. 7 illustrates XRD (X-ray diffraction) spectra for IGO layers manufactured by the methods according to IGO layer crystallinity evaluation examples 1 to 5, and FIG. 8 illustrates XRD spectra for IGO layers of TFTs manufactured by the methods according to TFT Preparation examples 1, 3, and 6. FIG. 9 illustrates XRD spectra for IGO layers of TFTs manufactured by the methods according to TFT Preparation examples 2, 3, 4, and 5, and FIG. 11 illustrates XRD spectra for IGO layers manufactured by the methods according to IGO layer crystallinity evaluation examples 6 to 8. In addition, Table 2 below summarizes the characteristics of the IGO layers obtained from the XRD spectra of the IGO layers of the TFTs manufactured by the methods according to TFT Preparation examples 1 to 6 and the IGO layers manufactured by the methods according to IGO layer crystallinity evaluation examples 1 to 8.

**[Table 2]**

| | State of IGO Layer | Intensity (222)/(400) | (222) Peak area percentage (%) | Texture Coefficient (TC222) | Vertical Grain Size (nm) |
|---|---|---|---|---|---|
| TFT Preparation Example 1 | Amorphous | - | - | - | - |
| TFT Preparation Example 2 | Amorphous | - | - | - | - |
| TFT Preparation Example 3 | Polycrystalline, (222) Preferred Orientation | 7.04 | 83.72 % | 2.88 | 16.03 nm |
| TFT Preparation Example 4 | Polycrystalline, Random Orientation | 1.19 | 45 % | 1.22 | 10.13 nm |
| TFT Preparation Example 5 | Polycrystalline, Random Orientation | 3.05 | 50.97 % | 1.98 | 13.03 nm |
| TFT Preparation Example 6 | Polycrystalline, Random Orientation | 1.2 | 45 % | 1.23 | 10.13 nm |
| IGO Crystallinity Evaluation Example 1 | Amorphous | - | - | - | - |
| IGO Crystallinity Evaluation Example 2 | Amorphous | - | - | - | - |
| IGO Crystallinity Evaluation Example 3 | Polycrystalline, (222) Preferred Orientation | 10.76 | 61.4 % | 2.52 | 13.28 |
| IGO Crystallinity Evaluation Example 4 | Polycrystalline, (222) Preferred Orientation | 6.74 | 79.82 % | 2.73 | 12.71 |
| IGO Crystallinity Evaluation Example 5 | Polycrystalline, Random Orientation | 1.52 | 47.63 % | 1.53 | 11.53 |
| IGO Crystallinity Evaluation Example 6 | Amorphous | - | - | - | - |
| IGO Crystallinity Evaluation Example 7 | Amorphous | - | - | - | - |
| IGO Crystallinity Evaluation Example 8 | Polycrystalline, Random Orientation | 1.24 | 49% | 1.35 | 12.65 nm |

Referring to FIG. 7, when the first heat treatment temperature, which is the heat treatment immediately after forming the IGO layer, is 450 °C or higher (IGO layer crystallinity evaluation examples 3 to 5), crystal peaks are observed in the IGO layer. Thus, it can be seen that the IGO layer is crystallized when the first heat treatment temperature is 450 °C or higher. On the other hand, when the first heat treatment temperature is 400 °C or lower (IGO layer crystallinity evaluation examples 1 and 2), no crystal peak is observed in the IGO layer. Thus, it can be seen that the IGO layer is in an amorphous state at a first heat treatment temperature of less than 450 °C, specifically, 400 °C or lower.

Referring to FIG. 8 and Table 2, in cases where the first heat treatment at 300, 400, or 500 °C / the second heat treatment at 200 °C / and the third heat treatment at 400 °C were performed as in TFT Preparation examples 1, 3, and 6, when the first heat treatment was 300 °C (TFT Preparation example 1), no crystal peak was observed in the IGO layer, indicating an amorphous state. On the other hand, when the first heat treatment was 400 °C (TFT Preparation example 3), crystal peaks were observed in the IGO layer, indicating crystallization, and the peak of the (222) plane appeared very strongly, showing preferred orientation in the [222] direction. Meanwhile, when the first heat treatment was 500 °C (TFT Preparation example 6), as various crystal planes were detected, it can be seen that the IGO layer is in a random polycrystalline state having crystals with randomly arranged crystal directions.

Referring to FIG. 7 and FIG. 8 simultaneously, when the first heat treatment was performed at 300 °C or 400 °C in TFT Preparation examples 1 and 3, the IGO layer is in an amorphous state immediately after the treatment, referring to IGO layer crystallinity evaluation examples 1 and 2. After the second heat treatment at 200 °C and the third heat treatment at 400 °C were subsequently performed, the IGO layer in TFT Preparation example 1, where the first heat treatment was performed at 300°C, remains in an amorphous state. However, in the IGO layer of TFT Preparation example 3, where the first heat treatment was performed at 400 °C, the peak of the (222) plane appears very strongly, indicating preferred orientation in the [222] direction. Meanwhile, immediately after the first heat treatment was performed at 500 °C in TFT Preparation example 6, the IGO layer is in a crystalline state preferentially oriented in the [222] direction, referring to IGO layer crystallinity evaluation example 4. However, after the second heat treatment at 200 °C and the third heat treatment at 400 °C were subsequently performed, it can be seen that the IGO layer changes to a random polycrystalline state.

From this, in order for the IGO layer to be in a preferentially oriented crystalline state, it may be preferable to perform the heat treatment immediately after forming the IGO layer at a temperature of higher than 300 °C and lower than 500 °C, specifically 350 to 450 °C, and more specifically 320 to 430 °C, so that the IGO layer is sufficiently heat-treated while remaining in an amorphous state.

Referring to FIG. 9 and Table 2, in cases where the first heat treatment at 400 °C / the second heat treatment at 200 °C / and the third heat treatment at 300, 400, 500, or 600 °C were performed as in TFT Preparation examples 2, 3, 4, and 5, when the third heat treatment was 300 °C (TFT Preparation example 2), no crystal peak was observed in the IGO layer, indicating an amorphous state. On the other hand, when the third heat treatment was 400, 500, or 600 °C (TFT Preparation examples 3, 4, and 5), crystal peaks were observed in the IGO layer, indicating crystallization. Specifically, when the third heat treatment was 400 °C (TFT Preparation example 3), the peak of the (222) plane appeared very strongly and the (222)/(400) peak ratio was 5 or more, specifically 7 or more, showing preferred orientation in the [222] direction. When the third heat treatment was 500 or 600 °C (TFT Preparation examples 4 and 5), the peak of the (222) plane was relatively weak, in other words, the (222)/(400) peak ratio was low at less than 5, which can be understood as having randomly oriented polycrystalline structures.

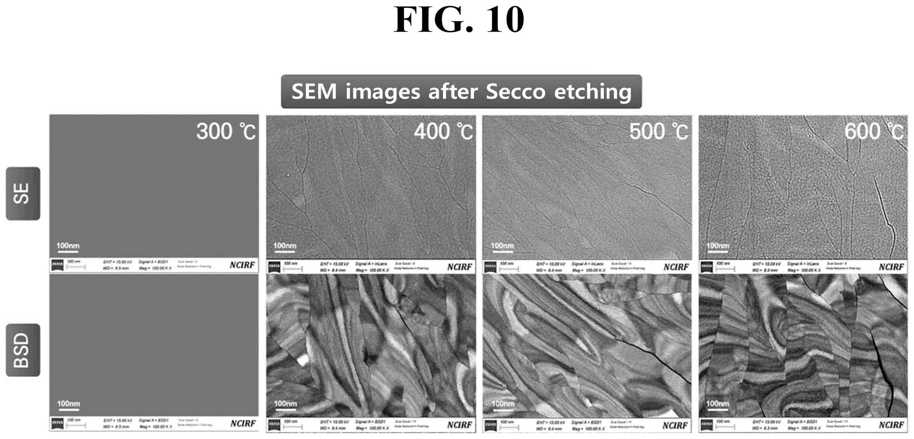

FIG. 10 shows scanning electron microscope (SEM) images of the IGO layers of the TFTs according to TFT Preparation examples 2, 3, 4, and 5, classified by the third heat treatment temperature. In FIG. 10, SE denotes a Secondary Electron image, and BSE denotes a Back-Scattered Electron image.

Referring to FIG. 10, in the case of TFT Preparation example 2 (third heat treatment temperature: 300 °C), no crystal peak is observed in the IGO layer, indicating an amorphous state. In the cases of TFT Preparation examples 3, 4, and 5 (third heat treatment temperature: 400, 500, or 600 °C), it can be seen that the IGO layer is in a polycrystalline state, as grain boundaries are identified in the surface of the IGO layer. However, referring to FIG. 9, it was estimated that a majority of crystals in the IGO layer of TFT Preparation example 3 were preferentially oriented in the (222) direction, while a majority of crystals in the IGO layers of TFT Preparation examples 4 and 5 were randomly oriented.

Referring to FIG. 8 and FIG. 11 simultaneously, in the case where the first heat treatment at 300 °C / the second heat treatment at 200 °C without stacking ITO / and the third heat treatment at 400 °C were performed in IGO layer crystallinity evaluation example 6, the IGO layer is shown to be in an amorphous state, similar to the case where the first heat treatment at 300 °C / the second heat treatment at 200 °C with ITO stacked / and the third heat treatment at 400 °C were performed in TFT Preparation example 1. In the case where the first heat treatment at 500 °C / the second heat treatment at 200 °C without stacking ITO / and the third heat treatment at 400 °C were performed in IGO layer crystallinity evaluation example 8, the IGO layer is shown to be in a random polycrystalline state, similar to the case where the first heat treatment at 500 °C / the second heat treatment at 200 °C with ITO stacked / and the third heat treatment at 400 °C were performed in TFT Preparation example 6. As such, when the first heat treatment was performed at 300 or 500 °C, the IGO layer exhibited a similar state regardless of whether the ITO layer was stacked.

On the other hand, in the case where the first heat treatment at 400 °C / the second heat treatment at 200 °C without stacking ITO / and the third heat treatment at 400 °C were performed in IGO layer crystallinity evaluation example 7, no crystal peak appeared other than the crystal peak of the Si substrate, indicating an amorphous state. In contrast, when the first heat treatment at 400 °C / the second heat treatment at 200 °C with ITO stacked / and the third heat treatment at 400 °C were performed in TFT Preparation example 3, as previously examined, crystal peaks were observed in the IGO layer, indicating crystallization, and the peak of the (222) plane appeared very strongly, showing preferred orientation in the [222] direction. Compared to IGO layer crystallinity evaluation example 7, it can be seen that in TFT Preparation example 3, the crystallization of IGO was promoted by the ITO crystallized at a temperature of 200 °C during the process of the third heat treatment at 400 °C. Specifically, it can be understood that the crystallization of IGO was induced by the crystallized ITO.

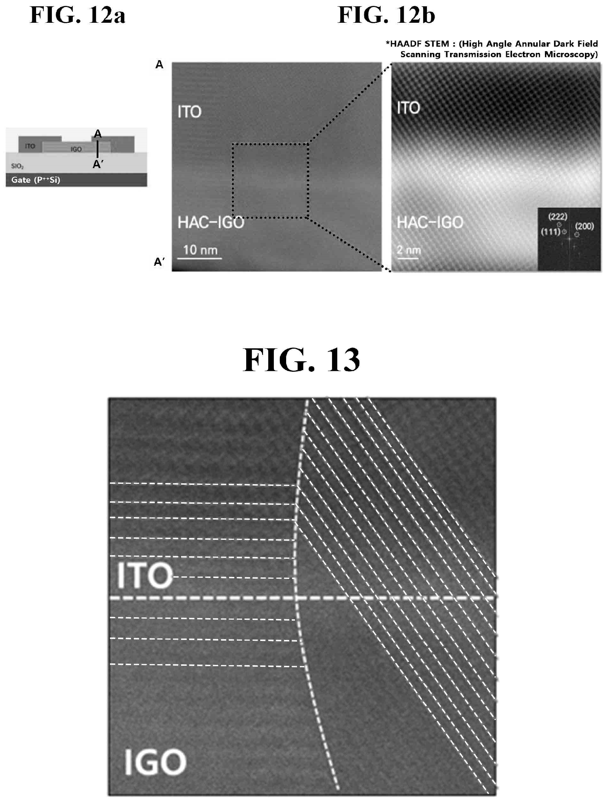

FIG. 12a shows a schematic view of the TFT obtained in TFT Preparation example 3, and FIG. 12b shows a TEM (Transmission Electron Microscopy) image taken along the cross-section A-A' of the TFT obtained in TFT Preparation example 3, an HAADF-STEM (High-Angle Annular Dark Field Scanning Transmission Electron Microscopy) image magnifying a portion of the TEM-imaged area, and an FFT (Fast Fourier Transform) pattern inserted therein. FIG. 13 is a TEM image of another portion of the cross-section A-A' of the TFT obtained in TFT Preparation example 3.

Referring to FIGS. 12a, 12b, and 12c, and FIG. 13, it can be seen that both the ITO layer and the IGO layer have an indium bixbyite crystal structure and are preferentially oriented in the (222) direction. In addition, the IGO layer has the same crystal lattice and crystallographic orientation as those of the ITO layer and has almost the same lattice constant, indicating that the IGO layer is lattice-matched to the ITO layer. From this, it can be estimated that the crystallized ITO layer serves as a template layer to induce crystallization or epitaxial crystallization of the IGO layer.

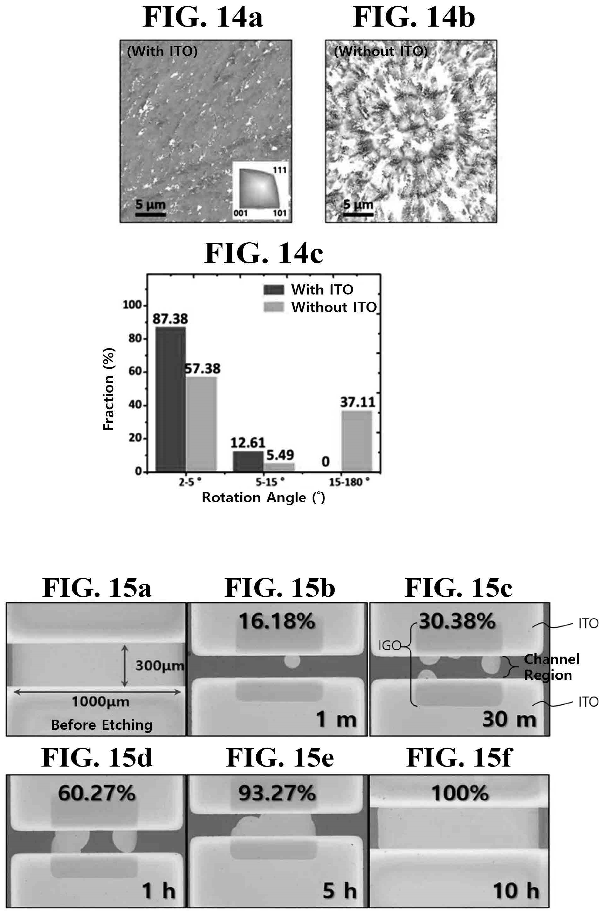

FIGS. 14a and 14b are EBSD (Electron Back Scattering Diffraction) images of IGO layers obtained according to TFT Preparation example 3 (with ITO) and IGO layer crystallinity evaluation example 7 (without ITO), respectively. FIG. 14c is a graph showing the distribution of grain boundaries with respect to the difference in grain orientation (rotation angle) obtained from FIGS. 14a and 14b.

Referring to FIGS. 14a, 14b, and 14c, the grain size of the IGO layer is larger in the case where the crystallization of IGO is induced by the crystallized ITO (with ITO) than in the case where it is not (without ITO). It can be seen that in the case where the crystallization of IGO is induced by the crystallized ITO (with ITO), the IGO layer includes low angle grain boundaries (LAGBs) where the orientation differences between grains are mainly distributed in 2-5 degrees and are overall distributed below 15 degrees.

FIGS. 15a, 15b, 15c, 15d, 15e, and 15f are images observing the crystals of samples prepared according to TFT Preparation Example 3, in which the third heat treatment was performed for 0 min (before treatment), 1 min, 30 min, 1 hr, 5 hr, and 10 hr, respectively. Here, the samples were etched using a Secco etchant (HF: K₂Cr₂O₇ = 2: 1) to confirm crystal growth, and crystals grown within the channel region are indicated in a light color.

Referring to FIGS. 15a, 15b, 15c, 15d, 15e, and 15f, as the third heat treatment time increases, it can be seen that the crystals in the IGO layer grow from the portion overlapped with the ITO toward the center of the channel region. These results may indicate that lateral induced crystallization of the IGO layer occurs by the ITO layer. Additionally, as in TFT Preparation example 3, when the third heat treatment is performed for 1 hour, it can be seen that the edge portion of the channel region is crystallized first while the central portion remains in an amorphous state.

Table 3 below is a table showing the characteristics of the TFTs obtained in TFT Preparation examples 1 to 6.

**[Table 3]**

| | State of IGO Layer | µFE | µSAT | SS | VTH |
|---|---|---|---|---|---|
| TFT Preparation Example 1 | Amorphous | 50.8 ± 8 | 48.1 ± 11.9 | 0.1 ± 0.02 | -1.22 ± 0.14 |
| TFT Preparation Example 2 | Amorphous | metallic | metallic | metallic | metallic |
| TFT Preparation Example 3 | Polycrystalline, (222) Preferred Orientation | 152.9 ± 23.8 | 149.4 ± 27.3 | 0.1 ± 0.01 | -1.18 ± 0.25 |
| TFT Preparation Example 4 | Polycrystalline, Random Orientation | 36.2 | 32.72 | 0.85 | -1.84 |
| TFT Preparation Example 5 | Polycrystalline, Random Orientation | 42.08 | 41.24 | 1.09 | -14.72 |
| TFT Preparation Example 6 | Polycrystalline, Random Orientation | 36.7 ± 1.1 | 11.8 ± 0.25 | 0.6 ± 0.04 | 0.96 ± 0.1 |

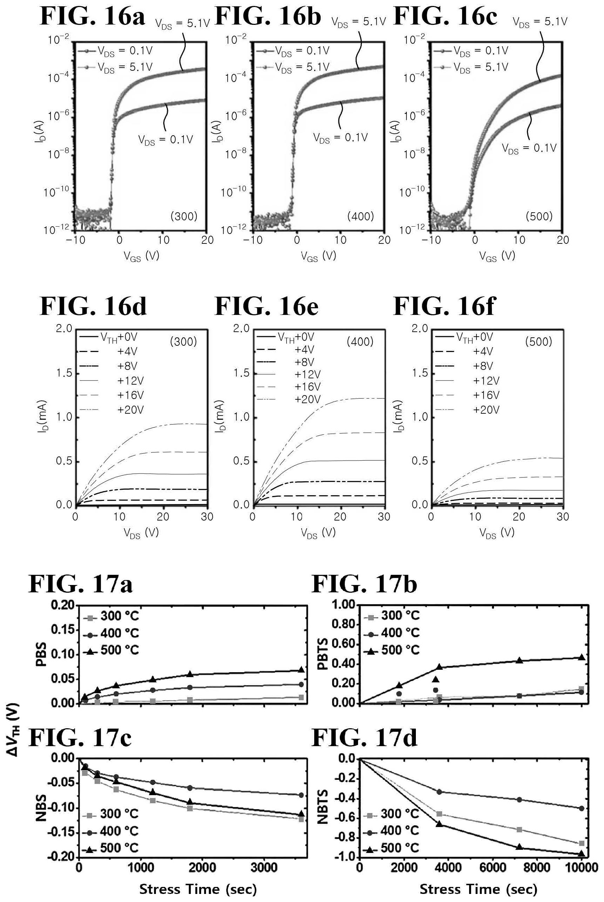

FIGS. 16a and 16d are graphs representing the transfer characteristics (I_{DS}-V_{GS}) and output characteristics (I_{D}-V_{D}) of the TFT obtained in TFT Preparation example 1, respectively. FIGS. 16b and 16e are graphs representing the transfer characteristics (I_{DS}-V_{GS}) and output characteristics (I_{D}-V_{D}) of the TFT obtained in TFT Preparation example 3, respectively. FIGS. 16c and 16f are graphs representing the transfer characteristics (I_{DS}-V_{GS}) and output characteristics (I_{D}-V_{D}) of the TFT obtained in TFT Preparation example 6, respectively. FIGS. 17a, 17b, 17c, and 17d are graphs illustrating the reliability characteristics of the TFTs obtained in TFT Preparation examples 1, 3, and 6, and shows the amount of threshold voltage shift according to stress time in PBS (Positive-Bias Stress), PBTS (Positive-Bias Temperature Stress), NBS (Negative-Bias Stress), and NBTS (Negative-Bias Temperature Stress), respectively.

Referring to FIGS. 16a, 16b, 16c, 16d, 16e, and 16f, and Table 3, the TFT according to TFT Preparation example 3, in which the first heat treatment was performed at 400 °C, exhibits excellent characteristics, such as a high mobility of 152.9 cm²/Vs and an SS characteristic of 0.1 V/decade, as the IGO layer was induced to crystallize during the third heat treatment. However, the TFT according to TFT Preparation example 1, in which the first heat treatment was performed at 300 °C, has an IGO layer in an amorphous state, and the TFT according to TFT Preparation example 6, in which the first heat treatment was performed at 500 °C, shows randomly oriented polycrystalline structures as the IGO layer was crystallized by simple thermal energy, thus exhibiting inferior characteristics compared to the TFT according to TFT Preparation example 3.

Referring to FIGS. 17a, 17b, 17c, and 17d, the TFT according to TFT Preparation example 3 exhibits excellent reliability characteristics, indicating that when the channel layer is crystallized by induced crystallization, the reliability characteristics are also improved.

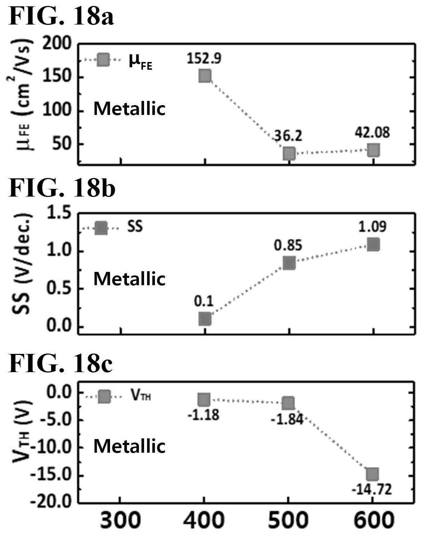

FIGS. 18a, 18b, and 18c are graphs comparing the mobility, SS, and threshold voltage of the TFTs obtained in TFT Preparation examples 2, 3, 4, and 5.

Referring to FIGS. 18a, 18b, and 18c, it can be seen that the TFT according to TFT Preparation example 3, where the third heat treatment temperature was 400 °C, exhibits the most excellent electrical characteristics, and as the third heat treatment temperature increases, the characteristics deteriorate.

### TFT Comparative Example 1

A TFT was fabricated in the same manner as in TFT Preparation Example 3, except that a shadow mask was placed on the IGO semiconductor layer subjected to the first heat treatment at 400 °C, and tungsten (W) was deposited using DC sputtering under an Ar atmosphere to form tungsten (W) source/drain electrodes instead of ITO source/drain electrodes.

### TFT Comparative Example 2

A TFT was fabricated in the same manner as in TFT Preparation Example 3, except that a shadow mask was placed on the IGO semiconductor layer subjected to the first heat treatment at 400 °C, and molybdenum (Mo) was deposited using DC sputtering under an Ar atmosphere to form molybdenum (Mo) source/drain electrodes instead of ITO source/drain electrodes.

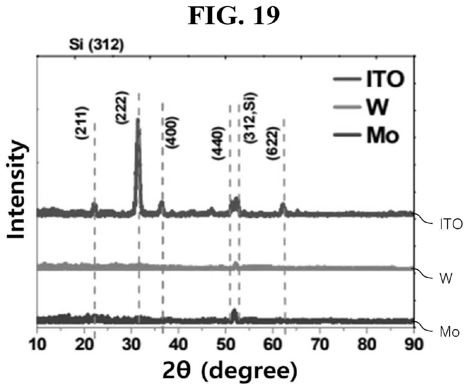

FIG. 19 shows XRD graphs for the IGO layers of the TFTs obtained in TFT Preparation Example 3, TFT Comparative Example 1, and TFT Comparative Example 2.

Referring to FIG. 19, it can be seen that the IGO layer of the TFT obtained in TFT Preparation Example 3 exhibits an indium bixbyite crystal structure preferentially oriented in the (222) direction, whereas the IGO layers of the TFTs obtained in TFT Comparative Example 1 and TFT Comparative Example 2 exhibit an amorphous structure.

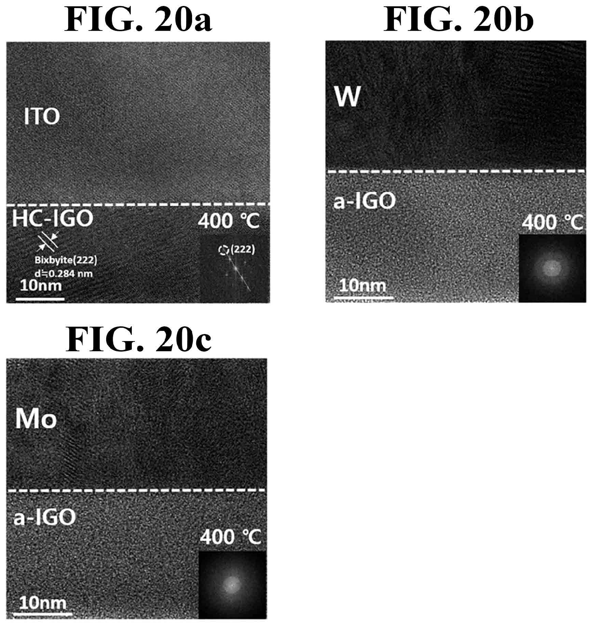

FIGS. 20a, 20b, and 20c show SEM images illustrating cross-sections of the portions where the source electrodes are stacked on the IGO layers of the TFTs obtained in TFT Preparation Example 3, TFT Comparative Example 1, and TFT Comparative Example 2, respectively, and further display FFT (fast Fourier transform) patterns inserted in these images.

Referring to FIGS. 20a, 20b, and 20c, the IGO layer of TFT Preparation Example 3 exhibits an indium bixbyite crystal structure preferentially oriented in the (222) direction, while the IGO layers of TFT Comparative Example 1 and TFT Comparative Example 2 exhibit an amorphous structure.

Referring to FIGS. 19, 20a, 20b, and 20c together, it can be seen that the crystallization of the IGO layer is induced by the crystallized ITO layer. The lattice mismatch degree of the IGO layer with respect to the ITO layer is very small at 2.35%; thus, it can be understood that the IGO layer is epitaxially crystallized from the ITO layer to be in a lattice-matched state.

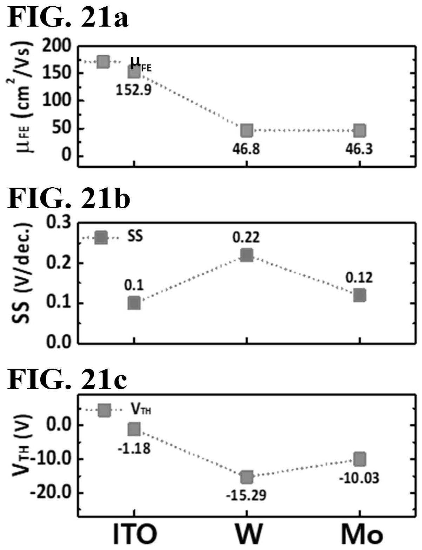

FIGS. 21a, 21b, and 21c are graphs comparing the mobility, SS, and threshold voltage of the TFTs obtained in TFT Preparation Example 3, TFT Comparative Example 1, and TFT Comparative Example 2.

Referring to FIGS. 21a, 21b, and 21c, it can be seen that the TFT according to TFT Preparation Example 3, which applies the ITO source/drain, exhibits the most excellent electrical characteristics.

### TFT Preparation Examples 7-9

A p-type Si wafer P⁺⁺ Si was thermally oxidized to grow a 100 nm SiO₂ layer on the p-type Si wafer. An IGZO channel layer having a composition of aIn_{0.77}Ga_{0.13}Zn_{0.1}O was deposited to a thickness of 20 nm on the SiO₂ layer using RF sputtering in an argon atmosphere with a shadow mask. The sputtering targets were In₂O₃, Ga₂O₃, and ZnO₂, the RF, DC1, and DC2 powers were 50W, 30W, and 10W, respectively, and the chamber pressure was 3 mTorr. Thereafter, the IGZO channel layer was heat-treated in air for 1 hour at the first heat treatment temperature shown in Table 4 below. In this way, TFTs were manufactured in the same manner as in TFT Preparation Example 3, except that an IGZO channel layer was formed instead of the IGO semiconductor layer and the first heat treatment temperature was varied.

### IGZO Layer Crystallinity Evaluation Examples 1-3

A p-type Si wafer P⁺⁺ Si was thermally oxidized to grow a 100 nm SiO₂ layer on the p-type Si wafer. An IGZO channel layer having a composition of aIn_{0.77}Ga_{0.13}Zn_{0.1}O was deposited to a thickness of 20 nm on the SiO₂ layer using RF sputtering in an argon atmosphere. The sputtering targets were In₂O₃, Ga₂O₃, and ZnO₂, the RF, DC1, and DC2 powers were 50W, 30W, and 10W, respectively, and the chamber pressure was 3 mTorr. Thereafter, the IGZO channel layer was heat-treated in air for 1 hour at the first heat treatment temperature shown in Table 4 below.

**[Table 4]**

| | 1^{st} Heat Treatment (Air, 1 hr) | 2^{nd} Heat Treatment (Air, 1 hr) | 3^{rd} Heat Treatment (Air, 1 hr) | State of IGZO Layer |
|---|---|---|---|---|
| TFT Preparation Example 7 | 300 °C | 200 °C | 400 °C | Polycrystalline, (222) Preferred Orientation |
| TFT Preparation Example 8 | 400 °C | 200 °C | 400 °C | Polycrystalline, (222) Preferred Orientation |
| TFT Preparation Example 6 | 500 °C | 200 °C | 400 °C | Polycrystalline, (222) Preferred Orientation |
| IGZO Crystallinity Evaluation Example 1 | 300 °C | - | - | Amorphous |
| IGZO Crystallinity Evaluation Example 2 | 400 °C | - | - | Amorphous |
| IGZO Crystallinity Evaluation Example 3 | 500 °C | - | - | Polycrystalline, (222) Preferred Orientation |

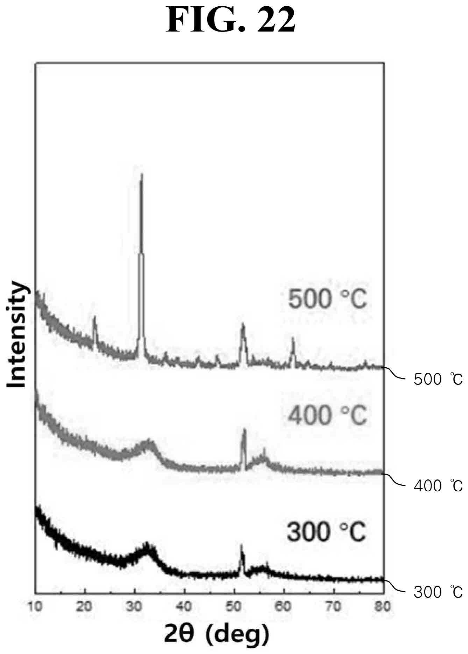

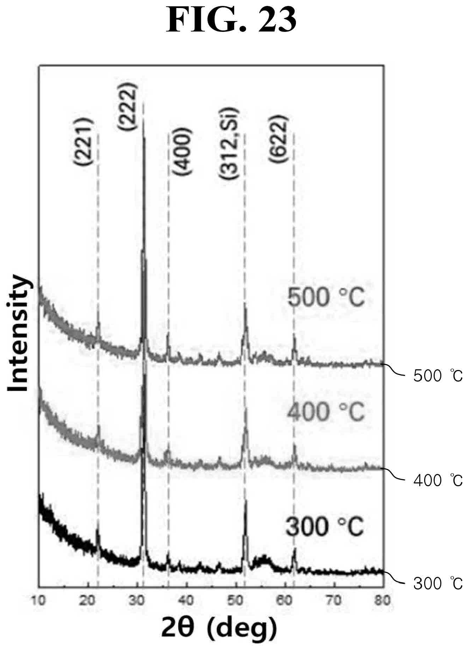

FIG. 22 shows XRD (X-ray diffraction) spectra for the IGZO layers manufactured by the method according to IGZO Layer Crystallinity Evaluation Examples 1 to 3, and FIG. 23 shows XRD spectra for the IGZO layers of the TFTs manufactured by the method according to TFT Preparation Examples 7, 8, and 9.

Referring to FIG. 22, it can be seen that the IGZO layer is crystallized to have an indium bixbyite structure only at a temperature of 500 °C or higher.

However, referring to FIG. 23, it can be seen that even when the IGZO layer is subjected to the first heat treatment at 300 °C or 400 °C, the crystallization of the IGZO layer is induced by the ITO layer crystallized at 200°C to have an indium bixbyite structure.

This research was conducted as a result of the Information and Communication Broadcasting Innovative Talent Training Program (Advanced Talent Training Program for AI Semiconductors) supported by the Ministry of Science and ICT (MSIT) and the Institute of Information & Communications Technology Planning & Evaluation (IITP) (IITP-(2025)-RS-2023-00253914).

While the present invention has been described in detail with reference to preferred embodiments, the present invention is not limited to the above embodiments, and various modifications and changes can be made by those skilled in the art within the technical spirit and scope of the present invention.

## Claims

1. A method of crystallizing an Indium-based (In-based) composite oxide semiconductor layer, the method comprising:
forming an In-based composite oxide semiconductor layer on a substrate, and performing a first heat treatment on the substrate to break metal-oxygen bonds in the In-based composite oxide semiconductor layer while maintaining an amorphous state;
forming In-based oxide conductor patterns on both ends of the In-based composite oxide semiconductor layer, and performing a second heat treatment on the substrate to crystallize the In-based oxide conductor patterns to have a bixbyite crystal structure; and
performing a third heat treatment on the substrate to induce crystallization of the In-based composite oxide semiconductor layer by the crystallized In-based oxide conductor patterns, thereby crystallizing the In-based composite oxide semiconductor layer to be preferentially oriented in a [222] direction.

2. The method of claim 1, wherein the In-based composite oxide semiconductor layer is a ternary oxide layer or a quaternary oxide layer containing another metal element in addition to indium.

3. The method of claim 2, wherein the ternary oxide is In-Ga-O (IGO) or In-Zn-O (IZO).

4. The method of claim 2, wherein the quaternary oxide is In-Ga-Zn-O (IGZO) or In-Zn-Sn-O (IZTO).

5. The method of claim 1, wherein the first heat treatment is performed at a temperature of greater than 300 °C and less than 500 °C.

6. The method of claim 5, wherein the first heat treatment is performed at a temperature of 350 °C to 450 °C.

7. The method of claim 1, wherein the first heat treatment is performed in an oxygen atmosphere for 0.5 to 2 hours.

8. The method of claim 1, wherein the In-based oxide conductor patterns are In-Sn-O (ITO) patterns or In-Zn-O (IZO) patterns.

9. The method of claim 1, wherein the second heat treatment is performed at a temperature of 180 °C to 220 °C.

10. The method of claim 1, wherein the In-based composite oxide semiconductor layer maintains an amorphous state even after the second heat treatment.

11. The method of claim 1, further comprising forming a passivation film covering the crystallized In-based oxide conductor patterns before performing the third heat treatment.

12. The method of claim 11, wherein the passivation film is a silicon oxide film.

13. The method of claim 1, wherein the crystallized In-based composite oxide semiconductor layer has a ratio of (222) peak intensity to (400) peak intensity of 6 to 8 in an XRD (X-ray diffraction) spectrum.

14. The method of claim 1, wherein a lattice mismatch degree between the crystallized In-based oxide conductor pattern and the In-based composite oxide semiconductor layer crystallized by induction therefrom is less than 2.5%.

15. The method of claim 1, wherein the crystallized In-based composite oxide semiconductor layer has a crystallinity that decreases in a direction from both ends in contact with the In-based oxide conductor patterns toward a central portion.

16. The method of claim 1, wherein, in the crystallized In-based composite oxide semiconductor layer, an edge portion of a region exposed between the In-based oxide conductor patterns is crystallized first, and a central portion of a region exposed between the In-based oxide conductor patterns remains in an amorphous state.

17. A method of manufacturing a thin film transistor, the method comprising:
forming a gate electrode on a substrate;
forming a gate insulating film on the gate electrode;
forming an In-based composite oxide semiconductor layer on the gate insulating film, and performing a first heat treatment on the substrate to break metal-oxygen bonds in the In-based composite oxide semiconductor layer while maintaining an amorphous state;
forming In-based oxide conductor patterns on both ends of the In-based composite oxide semiconductor layer, and performing a second heat treatment on the substrate to crystallize the In-based oxide conductor patterns to have a bixbyite crystal structure; and
performing a third heat treatment on the substrate to induce crystallization of the In-based composite oxide semiconductor layer by the crystallized In-based oxide conductor patterns, thereby crystallizing the In-based composite oxide semiconductor layer to be preferentially oriented in a [222] direction.

18. The method of claim 17, wherein the crystallized In-based oxide conductor patterns are source/drain electrodes.

19. A thin film transistor comprising:
a gate electrode;
an In-based composite oxide semiconductor layer overlapping the gate electrode, having a bixbyite crystal structure, and preferentially oriented in a [222] direction;
a gate insulating film disposed between the gate electrode and the In-based composite oxide semiconductor layer; and
source and drain electrodes respectively electrically connected to both ends of the In-based composite oxide semiconductor layer.

20. The thin film transistor of claim 19, wherein the In-based composite oxide semiconductor layer has a crystallinity that decreases in a direction from both ends toward a central portion.

21. The thin film transistor of claim 19, wherein in the In-based composite oxide semiconductor layer, an edge portion of a channel region between the In-based oxide conductor patterns is crystallized, and a central portion remains in an amorphous state.

22. The thin film transistor of claim 19, wherein the In-based composite oxide semiconductor layer has a ratio of (222) peak intensity to (400) peak intensity of 6 to 8 in an XRD (X-ray diffraction) spectrum.

23. The thin film transistor of claim 19, wherein the source/drain electrodes are crystallized In-based oxide conductor patterns having a bixbyite crystal structure.

24. The thin film transistor of claim 23, wherein the In-based composite oxide semiconductor layer is induced to be crystallized by the crystallized In-based oxide conductor patterns.

25. The thin film transistor of claim 24, wherein a lattice mismatch degree between the crystallized In-based oxide conductor pattern and the In-based composite oxide semiconductor layer crystallized by induction therefrom is less than 2.5%.
